# EUROPEAN PATENT SPECIFICATION

(11) **EP 2 672 535 B1**
(45) Date of publication and mention of the grant of the patent: **21.02.2018**
(21) Application number: 13167653.8
(22) Date of filing: 14.05.2013
(51) Int. Cl.: H01L 33/62, H01L 33/64, H01R 33/06, F21V 19/00, F21K 9/00

(54) **Housing used for electric parts**
Gehäuse für elektrische Teile
Boîtier utilisé pour des composants électriques

(30) Priority: 06.06.2012 JP 2012129049
(43) Date of publication of application: 11.12.2013
(60) Divisional application: 17165008.8
(73) Proprietor: Dai-Ichi Seiko Co., Ltd., Kyoto-shi, Kyoto 612-8024 (JP)
(72) Inventor: Endo, Takayoshi, Shizuoka, Shizuoka 4200857 (JP); Yagi, Sakai, Shizuoka, Shizuoka 4200857 (JP); Senmyou, Masaru, Shizuoka, Shizuoka 4200857 (JP)
(74) Representative: Winter, Brandl, Fürniss, Hübner, Röss, Kaiser, Polte - Partnerschaft mbB

(56) References cited:
- EP-A1- 1 211 735
- EP-A2- 2 034 529
- WO-A1-2011/150755
- JP-A- 2008 288 487
- JP-A- 2011 192 905
- KR-A- 20100 093 950
- US-A1- 2009 294 793
- US-A1- 2010 246 135
- US-A1- 2011 062 569

## Description

### BACKGROUND OF THE INVENTION

### FIELD OF THE INVENTION

The invention relates to a housing used for electric parts, capable of effectively radiating heat generated in an electric component which generates heat when a current runs therethrough.

### DESCRIPTION OF THE RELATED ART

An electric component such as a transistor, a diode, a resistor or a capacitor generates heat when a current runs therethrough. In particular, a light-emitting diode (LED) generates much heat, because a much current runs therethrough for accomplishing high luminance. If LED were kept at a high temperature, a lifetime thereof would be shortened. Accordingly, it is necessary to avoid a temperature of LED from rising, for instance, by radiating heat generated in electric components into ambient atmosphere, or transferring heat to other components.

For instance, Japanese Patent Application Publication No. 2008-288487 has suggested a light-emitting diode including a circuit board having a multi-layered structure. Intermediate layers are comprised of a copper foil pattern having a function of heat radiation. An upper surface electrode on which a LED chip is mounted is electrically connected to the intermediate layers through filled via-holes to thereby radiate heat generated in the LED chip into the intermediate layers.

EP 1 211 735 A1, US 2009 294 733 A1 and KR 2010 0 093 950 A each disclose a housing according to the preamble of claim 1.

### SUMMARY OF THE INVENTION

However, since heat is radiated to the intermediate layers comprised of a copper foil pattern in the above-mentioned conventional light-emitting diode, the circuit board has to be designed to have a multi-layered structure, resulting in the complexity in a structure thereof. Furthermore, a circuit board can be employed if an electric part is in the form of a thin plate, but it is not possible to apply the technique for manufacturing the circuit including intermediate layers to a housing used for an electric part and formed by resin molding in a three-dimensional shape.

In view of the above-mentioned problem in the prior art, it is an object of the present invention to provide a housing capable of preventing an electric part from rising in temperature, being formed in a simple structure, and further, being readily formed in a desired shape. The invention is defined by the appended claims. One of the aspect of the present invention is that it provides a housing used for an electric part, including a wire section electrically connected to an electric circuit including an electric component, and a housing body composed of resin, the wire section including a first terminal part exposed at a surface of the housing body, a second terminal part exposed at a surface of the housing body, and a thermally conductive part formed between the first terminal part and the second terminal part, and embedded in the housing body, the thermally conductive part has a width greater than the same of the first and second terminal parts.

In the housing in accordance with the present invention, heat generated in an electric part is radiated to the wire section. Since the wire section is designed to include the thermally conductive part embedded in the housing body, it is possible to radiate the heat into the housing body from the thermally conductive part. Since the heat is radiated into ambient atmosphere from the housing body, it is possible to prevent the temperature of the electric part from rising. Since the housing body can be formed by resin molding, the housing body can be formed in a desired two-dimensional or three-dimensional shape. Furthermore, since the housing can be manufactured only by embedding the thermally conductive part in resin, the housing is simple in structure.

It is preferable that the thermally conductive part has an area extensive almost over the housing body. For instance, the thermally conductive part may be designed to have an area almost equal to an area of the housing body. By designing the thermally conductive part to have an area as much as possible, an efficiency of heat radiation can be enhanced. The wire section is bent at least once. By bending the wire section at least once, the wire section can be longer than a wire section designed to be straight, ensuring a larger area of the thermally conductive part. The thermally conductive part comprises a plurality of vertically or horizontally arranged layers. By designing the thermally conductive part to have a plurality of layers, the thermally conductive part can have a greater area than an area of a thermally conductive part comprised of a single layer, ensuring a higher efficiency of heat radiation.

For instance, the adjacent layers may be designed to connect to each other through a bending part formed at peripheries of the adjacent layers.

It is preferable that the number of the layers is an odd number which equal to or greater than 3.

It is preferable that at least a part of the thermally conductive part is exposed externally of the housing body. By designing at least a part of the thermally conductive part to be exposed externally of the housing body, an efficiency of heat radiation can be enhanced.

For instance, at least a part of the thermally conductive part horizontally and/or vertically may be designed to project externally of the housing body. According to the present invention, the housing body may be formed with at least one hole leading to the thermally conductive part.

It is preferable that the housing body is formed by insert molding with the wire section being embedded therein. By carrying out insert molding, it is possible to readily embed the thermally conductive part in the housing body at a desired location, when the housing body is formed.

It is preferable that the electric circuit comprises a pattern comprising a thin metal film electrically connected to the electric component, the pattern being formed by a wiring pattern transfer process in which a thin metal film sheet is dice-cut, and the dice-cut sheet is tranferred to the housing body.

The wiring pattern transfer process makes it possible to directly form a thin metal film pattern in the housing body formed by resin molding, and hence, it is possible to radiate heat generated in an electric component directly to ambient atmosphere or through the pattern comprised of a thin metal film, or to the housing body, preventing a temperature of the electric component from rising.

### ADVANTAGES OBTAINED BY THE INVENTION

In accordance with the present invention, the heat generated in the electric circuit is radiated into the housing body through the thermally conductive part. Since the housing body in which the thermally conductive part is embedded is formed by resin molding, the housing can be readily formed in a desired shape in a simple structure with a temperature at the electric component being prevented from rising.

This disclosure contains embodiments from which some are embodiments of the invention.

### BRIEF DESCRIPTION OF THE DRAWINGS

Figure 1 is a perspective view of the LED lamp in accordance with the first embodiment.
Figure 2 is a plan view of the LED lamp illustrated in Figure 1.
Figure 3 is a circuit diagram of the electric circuit included in the LED lamp illustrated in Figure 1.
Figure 4 is a cross-sectional view taken along the line A-A in Figure 2.
Figure 5 is a perspective view of the wire section included in the LED lamp illustrated in Figure 2.
Figure 6 is a perspective view of the LED lamp including the first terminal part as a variant.
Figure 7 is a cross-sectional view of the LED lamp illustrated in Figure 6.
Figure 8 is a cross-sectional view of the LED lamp in accordance with the second embodiment of the present invention.
Figure 9 is a perspective view of the wire section included in the LED lamp illustrated in Figure 8.
Figure 10 is a perspective view showing a process of embedding the wire section illustrated in Figure 8 into the housing main body by insert molding.
Figure 11(A) is a front view of the wire section illustrated in Figure 10.
Figure 11(B) is a cross-sectional view taken along the line B-B in Figure 11(A).
Figure 12 is a perspective view of the housing formed by insert molding.
Figure 13 is a perspective view of the housing illustrated in Figure 12 on which the circuit patterns are formed.
Figure 14 is a perspective view of the wire section included in the LED lamp in accordance with the third embodiment.
Figure 15 is a cross-sectional view of the LED lamp in accordance with the third embodiment.
Figure 16 is a cross-sectional view of the LED lamp in accordance with the fourth embodiment according to the present invention.
Figure 17 is a cross-sectional view of the LED lamp in accordance with a variant of the fourth embodiment.
Figure 18 is a cross-sectional view of the LED lamp in accordance with the fifth embodiment.
Figure 19 is a perspective view of the LED lamp in accordance with the sixth embodiment.
Figure 20 is a perspective view of the wire section included in the LED lamp illustrated in Figure 19.
Figure 21 is a perspective view of the LED lamp in accordance with the seventh embodiment.
Figure 22 is a perspective view of the wire section included in the LED lamp illustrated in Figure 20.

### DESCRIPTION OF THE EMBODIMENTS

### (First Embodiment)

The housing in accordance with the first embodiment is applied to a LED lamp.

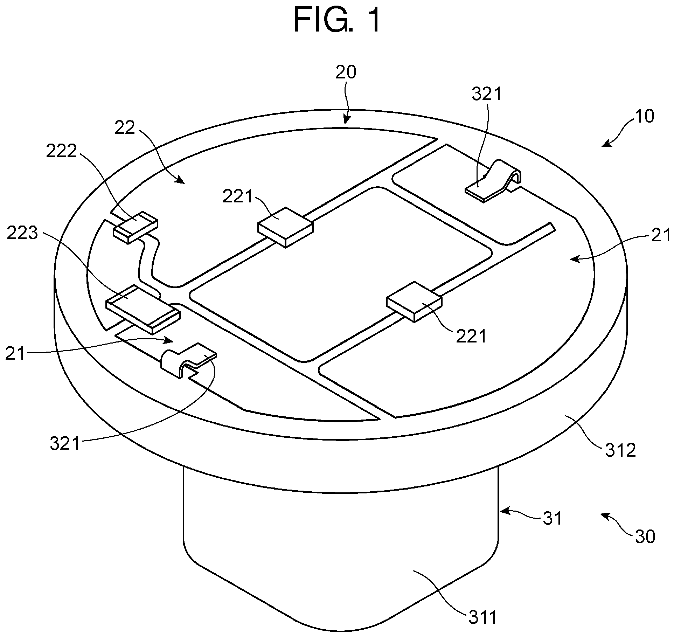

A LED lamp 10 can be used as a head light, a position light, a winker, a brake light and so on in an automobile. As illustrated in Figure 1, the LED lamp 10 includes an electric circuit 20 and a housing 30.

The electric circuit 20 includes circuit patterns 21 each comprised of a thin metal film, and electric components 22 electrically connected to the circuit patterns 22.

Each of the circuit patterns 21 is comprised of a patterned thin metal film, and can be formed by a wiring pattern transfer process in which a thin metal film sheet is dice-cut, and the dice-cut sheet is tranferred onto a surface of the housing 30 (a surface on which the electric circuit 20 is formed).

The electric components 22 in the first embodiment includes, as an example for defining a LED lamp, two LEDs 221, a chip resistor 222, and a diode 223, all mounted on the circuit patterns 21.

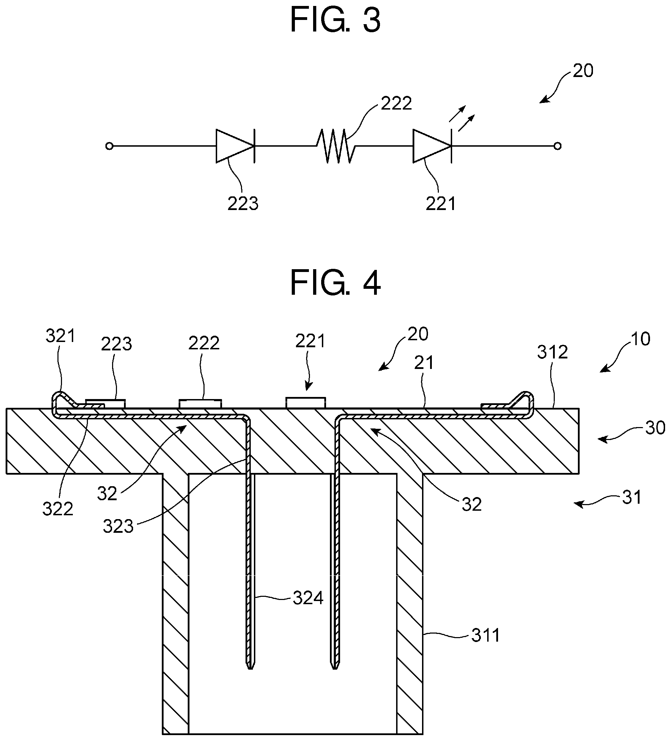

The circuit patterns 21 and the electric components 22 define the electric circuit 20 having a structure as illustrated in Figure 3. In the circuit illustrated in Figure 3, a LED 221, a chip resistor 222 and a diode 223 are electrically connected in series to one another.

As illustrated in Figure 4, the housing 30 is comprised of molded resin formed by inserting molding. The housing 30 includes a housing main body 31, and a wire section 32 which provides electric power to the electric circuit 20. The housing main body 31 includes a base 311 to be fit into an electric power source (not illustrated), and a flange 312 which is formed at a top of the base 311 and on which the electric circuit 20 is formed.

The base 311 is substantially cylindrical. The flange 312 is in the form of a disc having a diameter greater than the same of the base 311.

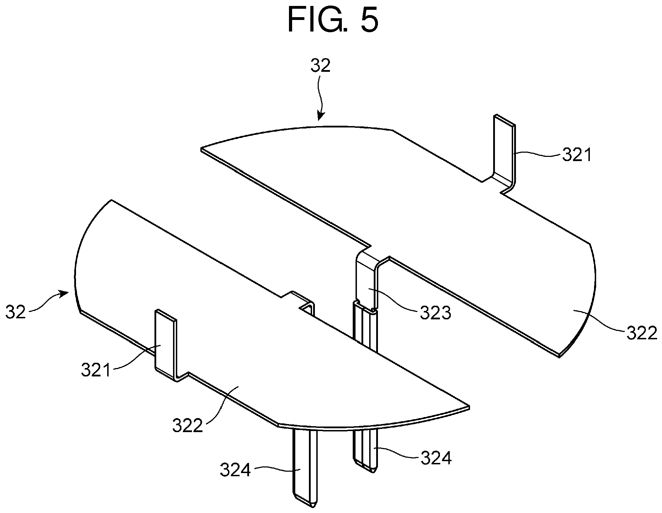

As illustrated in Figures. 4 and 5, the wire section 32 includes a first terminal part 321 electrically connected to the circuit patterns 21 of the electric circuit 20, a thermally conductive part 322 embedded in the housing main body 31, a downwardly extending junction part 323, and a second terminal part 324 projecting externally of the flange 312 into a space formed in the base 311. The wire section 32 can be formed by pressing a metal plate.

The first terminal part 321 is formed by bending a distal end of the wire section 32 externally projecting through a surface of the flange 312 to thereby make surface contact with the circuit patterns 21 (see Figure 1). The first terminal part 321 is soldered to the circuit patterns 21. Figure 5 illustrates the first terminal part 321 at such a shape as before it is bent.

The thermally conductive part 322 is formed between a bent portion of the first terminal part 321 and a bent portion of the junction part 323. As illustrated in Figure 5, the thermally conductive part 322 is designed to have a width greater than widths of the first terminal part 321 and the junction part 323 between which the thermally conductive part 322 is formed. In the first embodiment, the thermally conductive part 322 is designed to be almost trapezoidal, having an oblique line which is arcuate along a circular periphery of the flange 312.

The second terminal part 324 exposed externally of the flange 312, and is designed to be thick by folding a portion having a width greater than the same of the junction part 323 in order to enhance a strength of the second terminal part 324.

The LED lamp 10 having the above-mentioned structure, in accordance with the first embodiment, is used as follows.

By fitting the LED lamp 10 into a power supply, electric power is supplied to the electric circuit 20 through the second terminal part 324 and then the first terminal part 321.

In the electric circuit 20, electric power is supplied to LED 221 through both the chip resistor 222 and the diode 223 from the circuit patterns 21 to which the first terminal part 321 is electrically connected. Thus, LED 221 emits light.

When LED 221 emits light, it generates heat. The thus generated heat partially radiates through the circuit patterns 21 formed by the wire pattern transfer process to have an increased width generate heat, and partially transfers into the housing 30 from the circuit patterns 21. The heat having transferred into the housing 30 is radiated externally of the LED lamp 10. The heat having transferred to the circuit patterns 21 further transfers to the thermally conductive part 322 through the first terminal part 321.

Since the thermally conductive part 322 is designed to have an area larger than the first and second terminal parts 321 and 324, the thermally conductive part 322 can have a large area at which the thermally conductive part 322 makes contact with the housing main body 31. Accordingly, the heat having transferred to the thermally conductive part 322 can be effectively transferred to the housing main body 31, and further, the heat having transferred to the housing main body 31 can be radiated to ambient atmosphere therearound. Furthermore, the heat having transferred to the thermally conductive part 322 can be partially transferred to an electric power source through the junction part 323 and the second terminal part 324.

Furthermore, since the thermally conductive part 322 is located in parallel with and in the vicinity of a surface of the flange 312 on which the circuit patterns 21 are formed, the heat having transferred to the thermally conductive part 322 through the housing main body 31 from the circuit patterns 21 can be spread to entire housing main body 31, and then, radiated out of the housing main body 31.

As mentioned above, since the heat having transferred to the thermally conductive part 322 is radiated to ambient atmosphere through the housing 30, it is possible to avoid a temperature of LED 221, an electric component, from rising. Since the housing 30 is formed by resin molding, the housing 30 can be readily formed to a desired shape, even if it is two-dimensional or three-dimensional. Furthermore, since the housing 30 in which the wire section 32 is embedded and which is composed of resin is formed by insert molding, the housing 30 can be formed in a simple structure, and the wire section 32 can be embedded in the housing 30 at a desired location.

In the first embodiment, the wire section 32 is perpendicularly bent between the first terminal part 321 and the thermally conductive part 322, the thermally conductive part 322 is located in parallel with a surface of the flange 312, and the wire section 32 is further bent between the thermally conductive part 322 and the junction part 323, and accordingly, the wire section 32 can have a path longer than a path of a wire section straightly formed from a bottom of the flange 312 to the first terminal part 312. Thus, since it is possible to design the thermally conductive part 322 to have a large area, heat can be effectively transferred to the housing main body 31 from the thermally conductive part 32.

By forming the circuit patterns 21 by means of the wire pattern transfer process, the circuit patterns 21 can be formed as a widespread plain pattern, heat having transferred from LED 221 can be radiated out of the circuit patterns 21.

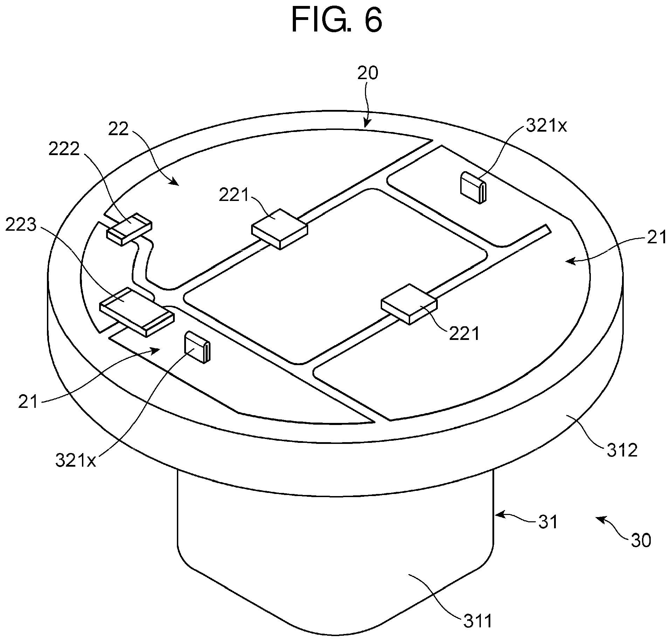

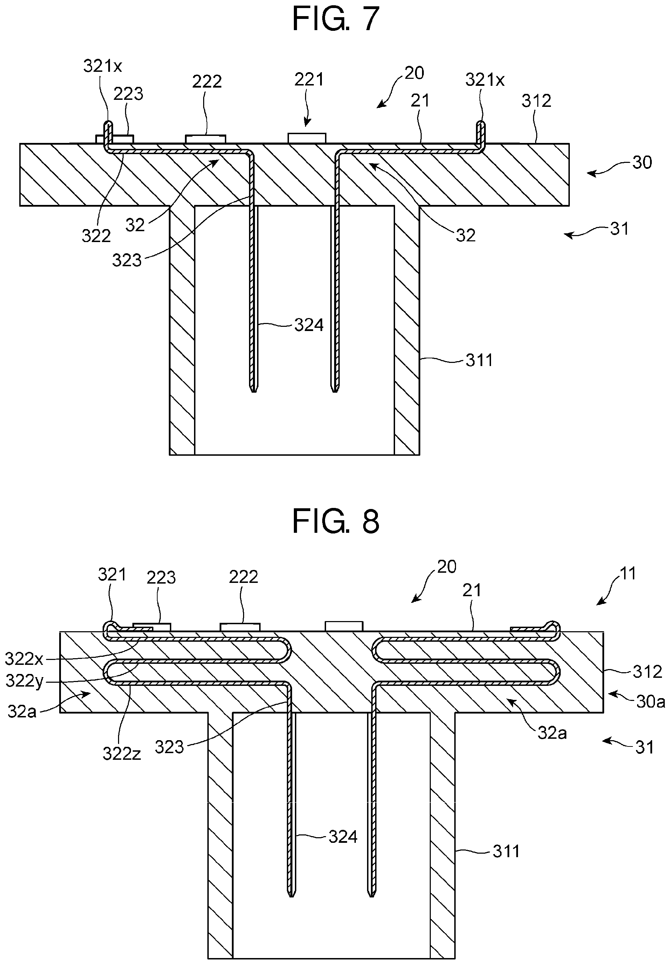

In the LED lamp 10 in accordance with first embodiment, the first terminal part 321 is bent at a distal end thereof to thereby make surface contact with the circuit patterns 21. Instead, as illustrated in Figures 6 and 7, the first terminal part 321x may be formed by folding a distal end of the wire section 32, and a portion of the wire section 32, exposed out of the housing main body 31, may be soldered to the housing 30.

### (Second Embodiment)

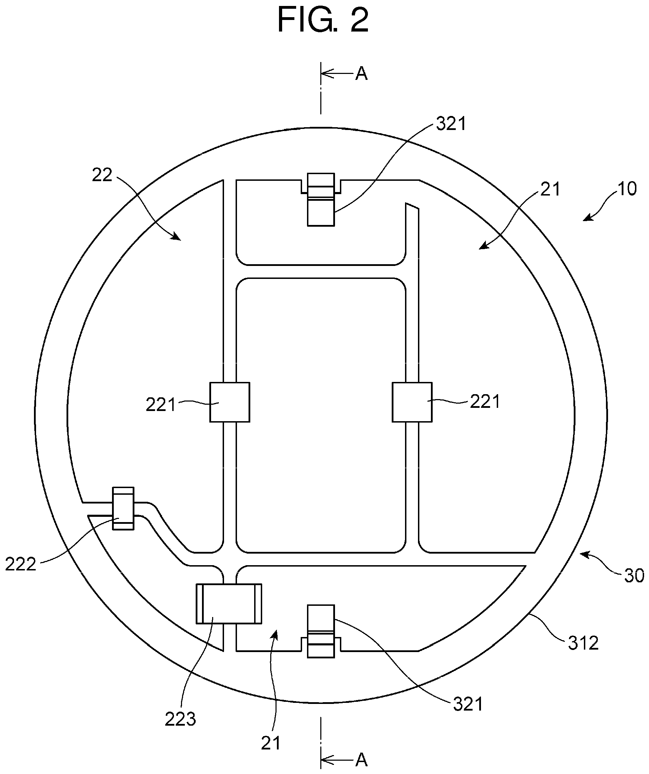

A housing to be used for an LED lamp, in accordance with the second embodiment, which is an embodiment of the present invention is explained hereinbelow with reference to drawings. The LED lamp in accordance with the second embodiment is characterized in including a thermally conductive part comprising a plurality of layers. In Figures 8 to 13, parts or elements that correspond to those of the first embodiment illustrated in Figures 1 to 7 have been provided with the same reference numerals, and operate in the same manner as corresponding parts or elements in the first embodiment, unless explicitly explained hereinbelow.

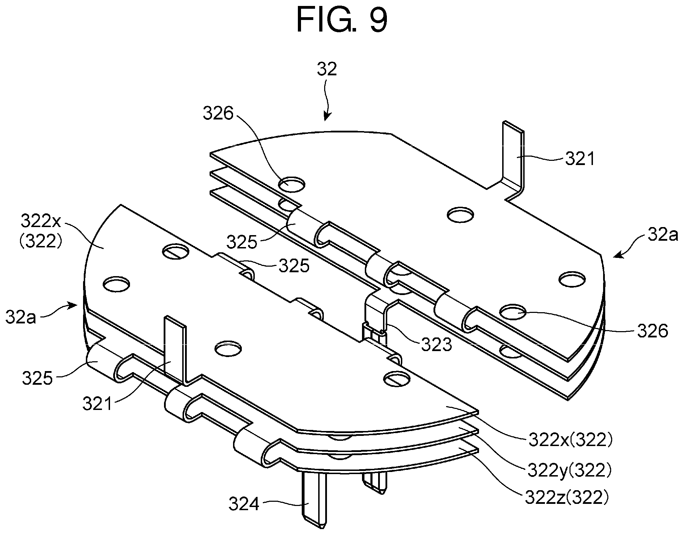

As illustrated in Figures 8 and 9, LED lamp 11 in accordance with the second embodiment includes a wire section 32a having a thermally conductive part 322 between the first terminal part 321 and the junction part 323. The thermally conductive part 322 comprises vertically arranged three layers, that is, first to third thermally conductive parts 322x, 322y and 322z.

As illustrated in Figure 9, the first to third thermally conductive parts 322x, 322y and 322z are connected to one another through a bending part 325, and thus, the first to third thermally conductive parts 322x, 322y and 322z can be formed of a single plate. Specifically, the first thermally conductive part 322x starts at a bending portion at one end of the first terminal part 321, and is connected to the second thermally conductive part 322y through the bending part 325. Then, the second thermally conductive part 322y is connected to the third thermally conductive part 322z through the bending part 325. Thus, the first and second thermally conductive parts 322x and 322y define a reciprocated route via the bending part 325 in the wire section 32a. Furthermore, since the third thermally conductive part 322z is connected to the second thermally conductive part 322y via the bending part 325, the second terminal part 324 can be designed to project out of a lower surface of the flange 312 at a center of the flange 312, similarly to the LED lamp 10 in accordance with the first embodiment. The bending part 325 comprises three parts for connecting the first to third thermally conductive parts 322x to 322z to one another.

As illustrated in Figure. 9, each of the first to third thermally conductive parts 322x to 322z arranged in parallel with one another is formed with through-holes 326 into which a pole can be perpendicularly inserted.

Herein, a process for forming the housing main body 31 by insert molding with the wire section 32a being embedded therein is explained with reference to drawings.

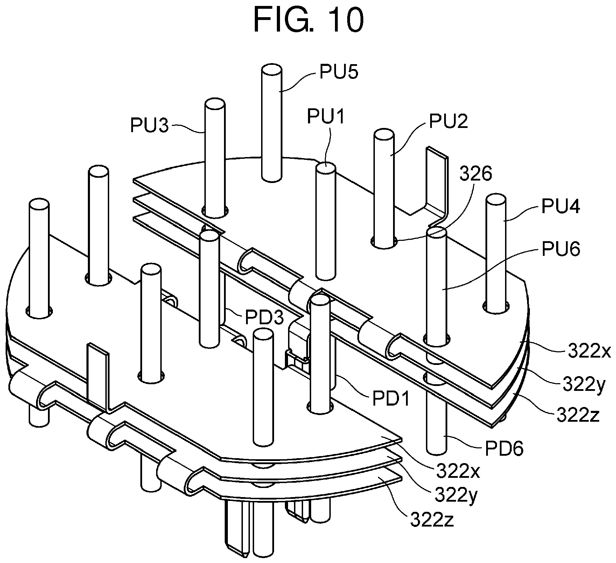

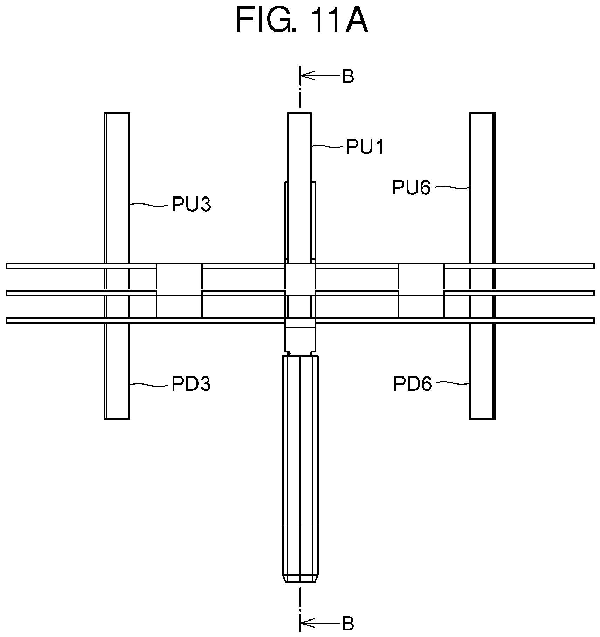

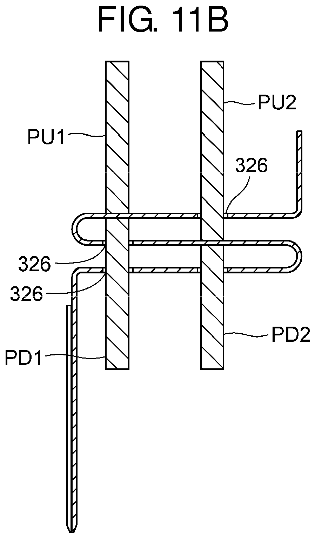

As illustrated in Figures 10 and 11, in the insert molding, poles for fixation PU1 to PU6 compress one of upper and lower surfaces (upper surfaces in Figure 10) of the first to third thermally conductive parts 322x to 322z, and poles for fixation PD1 to PD6 compress the other surfaces (lower surfaces in Figure 10) of the first to third thermally conductive parts 322x to 322z to thereby sandwich the first to third thermally conductive parts 322x to 322z between the poles PU1 to PU6 and the poles PD1 to PD6.

For instance, as illustrated in Figure 11(B), the pole PU1 compresses an upper surface of the first thermally conductive part 322x, and the pole PD1 facing the pole PU1, which passes through the through-hole 326 of the third thermally conductive part 322z and the through-hole of the second thermally conductive part 322y, compresses a lower surface of the first thermally conductive part 322x. Thus, the first thermally conductive part 322x is sandwiched by the poles PU1 and PD1.

Similarly to the poles PU1 and PD1, as illustrated in Figure 11(B), the pole PU2 passes through the through-hole 326 of the first thermally conductive part 322x and compresses an upper surface of the second thermally conductive part 322y, and the pole PD2 facing the pole PU2 passes through the through-hole 326 of the third thermally conductive part 322z and compresses a lower surface of the second thermally conductive part 322y. Thus, the second thermally conductive part 322y is sandwiched by the poles PU2 and PD2.

Similarly, the poles PU3 and PD3 sandwiches the third thermally conductive part 322z therebetween, the poles PU4 and PD4 sandwiches the third thermally conductive part 322z therebetween, the poles PU5 and PD5 sandwiches the first thermally conductive part 322x therebetween, and the poles PU6 and PD6 sandwiches the second thermally conductive part 322y therebetween.

By sandwiching the first to third thermally conductive parts 322x to 322z between the poles PU1 to PU6 and the poles PD1 to PD6, the first to third thermally conductive parts 322x to 322z can be spaced away from one another by a certain distance, even if molten resin flowed into a metal mold.

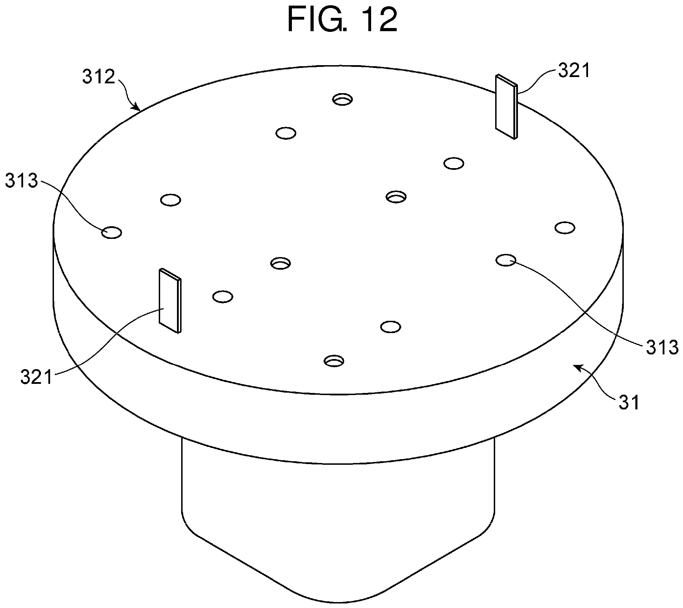

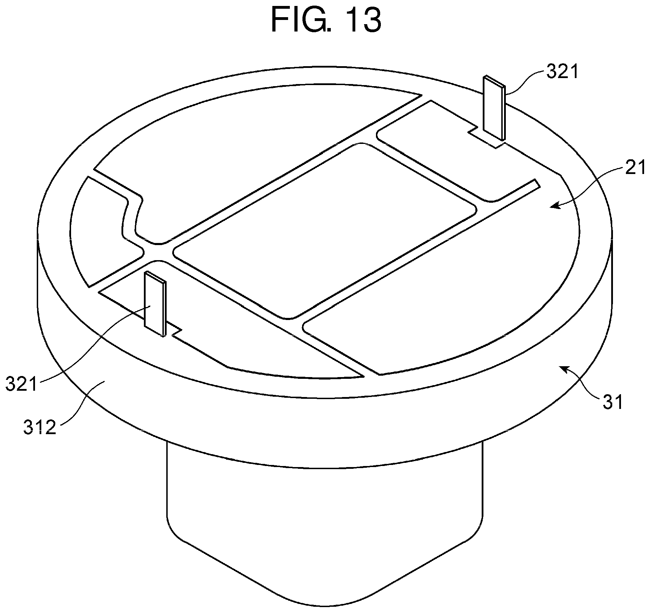

As illustrated in Figure 12, the housing main body 31 in which the thermally conductive part 322 is embedded and which is formed by insert molding is formed holes 313 due to the poles PU1 to PU6 and PD1 to PD6. However, as illustrated in Figure 13, since the circuit patterns 21 are formed by the wire pattern transfer process on an upper surface of the flange 312 of the housing main body 31, the holes 313 (see Figure 12) are closed, resulting in that the holes 313 cannot be seen in appearance of the housing 30.

As mentioned above, since the LED lamp 11 in accordance with the second embodiment includes the housing 30a having the multi-layered thermally conductive part 322, the thermally conductive part 322 can have a large area, ensuring heat radiation at a high efficiency. Furthermore, since the first to third thermally conductive parts 322x to 322z are arranged in parallel to one another by a certain distance, the thermally conductive part 322 can be designed to have a multi-layered structure, ensuring that the thermally conductive part 322 can have a larger area in a small volume of the housing main body 31.

In the LED lamp 11 in accordance with the second embodiment, the first to third thermally conductive parts 322x to 322z are designed to be identical in shape with one another. Instead, the first to third thermally conductive parts 322x to 322z may be designed to be different in shape from one another in dependence on a shape of the housing 30.

### (Third Embodiment)

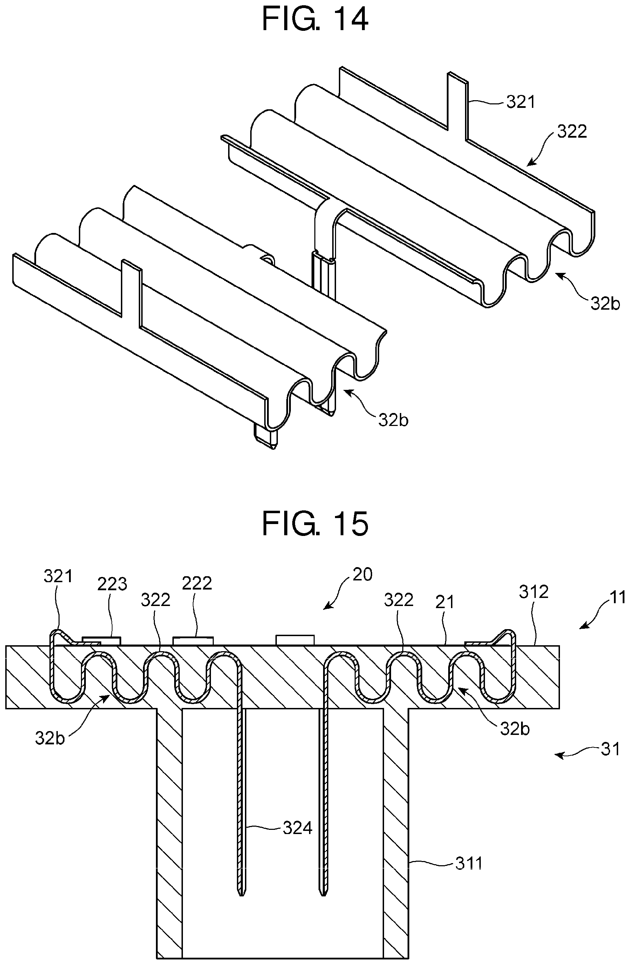

Figure 14 is a perspective view of the wire section 32b to be employed in the housing in accordance with the third embodiment, and Figure 15 is cross-sectional view of the housing in accordance with the third embodiment.

In the second embodiment, as illustrated in Figure 8, the thermally conductive part 322 is designed to have a multi-layered structure including the first to third thermally conductive parts 322x , 322y and 322z vertically arranged. In the third embodiment, the thermally conductive part 322 is designed to have a multi-layered structure including a plurality of layers horizontally arranged. The thermally conductive part 322 may be designed to have a multi-layered structure including any number of layers.

The third embodiment provides the same advantages as those provided by the second embodiment.

### (Fourth Embodiment)

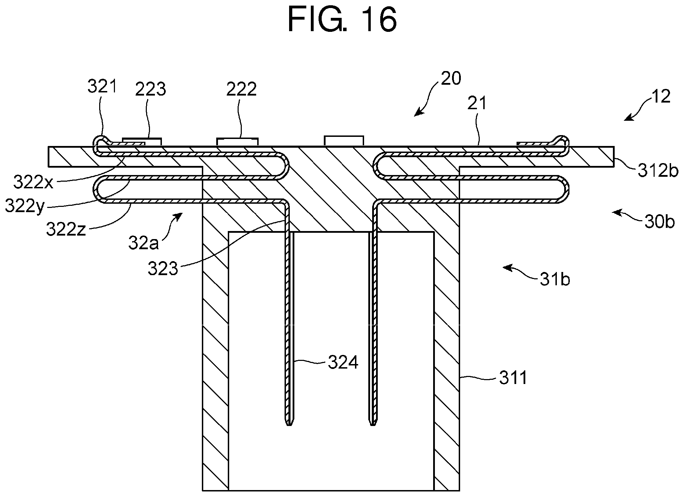

The housing in accordance with the fourth embodiment of the present invention is explained hereinbelow with reference to drawings. In Figure 16, parts or elements that correspond to those of the first embodiment illustrated in Figure 8 have been provided with the same reference numerals, and operate in the same manner as corresponding parts or elements in the first embodiment, unless explicitly explained hereinbelow.

As described later, the housing in accordance with the fourth embodiment is characterized that the thermally conductive part is partially exposed out of the housing 30b.

The flange 312b of LED lamp 12 illustrated in Figure 16 is designed to have a thickness smaller than the flange 312 illustrated in Figure 8, and accordingly, the thermally conductive part 322 is partially exposed out of the housing main body 31b.

In the fourth embodiment, a half of the second thermally conductive part 322y, a half of the third thermally conductive part 322z, and the bending part 325 connecting the second thermally conductive part 322y and the third thermally conductive part 322z to each other are exposed out of the housing main body 31b.

By designing the thermally conductive part 322 to be partially exposed out of the housing main body 31b, it is possible to radiate heat to ambient atmosphere as well as the housing 30b, temperature of LED 221 can be prevented from rising.

Though a part of the second thermally conductive part 322y, a part of the third thermally conductive part 322z, and the bending part 325 connecting the second thermally conductive part 322y and the third thermally conductive part 322z to each other are exposed out of the housing main body 31b, the second and third thermally conductive parts 322y and 322z may be entirely exposed out of the housing main body 31b, or only the third thermally conductive part 322z may be partially or entirely exposed out of the housing main body 31b.

In order to expose the wire section 32a out of the flange 312 illustrated in Figure 8, the thermally conductive part 322 embedded in the flange 312 may be bent to thereby downwardly project out of an outer periphery of the flange 312, for instance. The wire section 32a may be designed to have any shape such that the thermally conductive part 322 embedded therein is partially or entirely exposed out of the housing main body 31.

Similarly, the thermally conductive part 322 of the wire section 32 in the first embodiment (see Figure 4) may be designed to be partially or entirely exposed out of the housing main body 31.

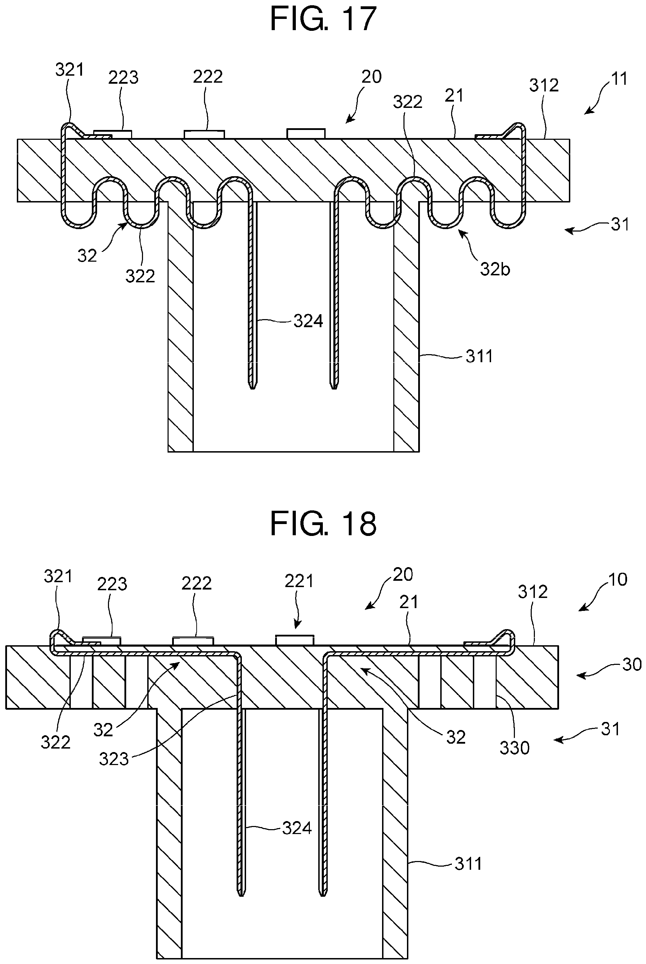

Similarly, the thermally conductive part 322 of the wire section 32b in the third embodiment (see Figure 15) may be designed to be partially or entirely exposed out of the housing main body 31, as illustrated in Figure 17.

### (Fifth Embodiment)

Figure 18 is a cross-sectional view of the housing in accordance with the fifth embodiment. In the above-mentioned fourth embodiment, the thermally conductive part 322 is designed to project out of the housing main body 31, as illustrated in Figures 17 and 18.

In the fifth embodiment, as illustrated in Figure 18, the housing 31 is formed with holes 330 leading to the thermally conductive part 322, and thus, the thermally conductive part 322 is exposed to atmosphere through the holes 330.

Thus, heat having transferred to the thermally conductive part 322 can be radiated to ambient atmosphere through the holes 330.

The housing in accordance with the fifth embodiment can provide the same advantages as those provided by the housing in accordance with the fourth embodiment.

### (Sixth Embodiment)

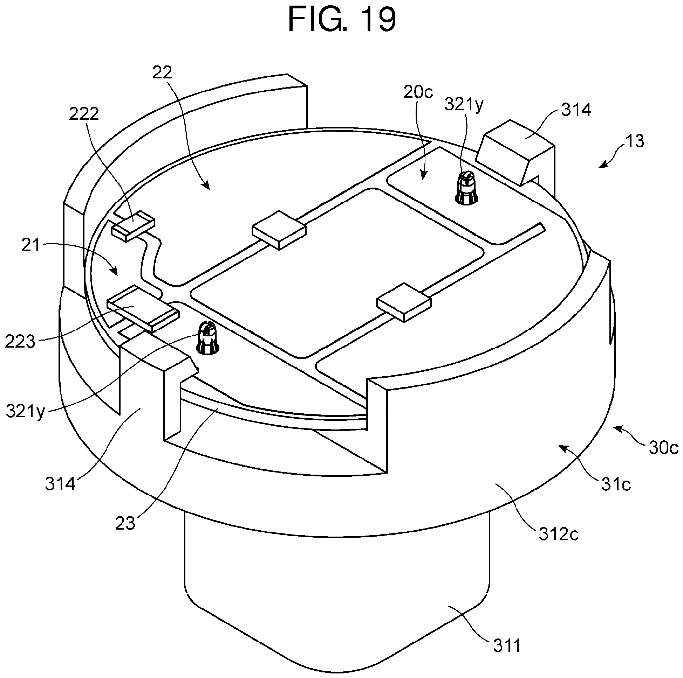

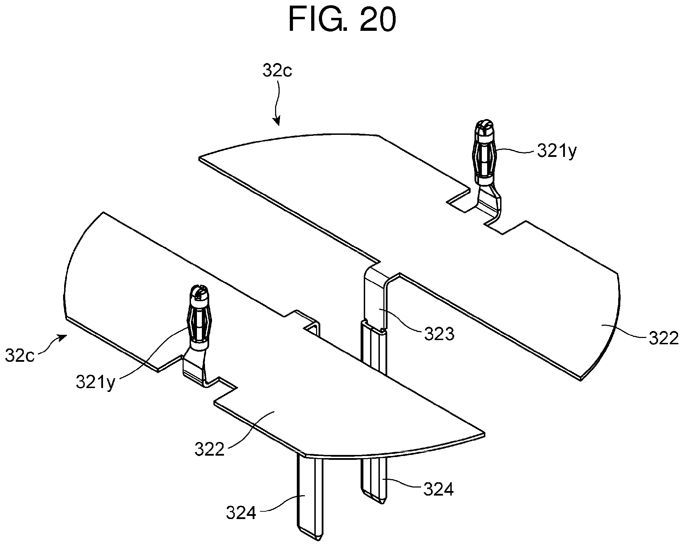

The housing in accordance with the sixth embodiment is explained hereinbelow with reference to drawings. In Figures 19 and 20, parts or elements that correspond to those of the first embodiment illustrated in Figures 1 and 5 have been provided with the same reference numerals, and operated in the same manner as corresponding parts or elements in the first embodiment, unless explicitly explained hereinbelow.

The housing in accordance with the sixth embodiment is characterized in that the electric circuit 20 comprises a circuit board.

In the housing 30c to be used for LED lamp 13, illustrated in Figures 19 and 20, the flange 312c of the housing main body 31c is formed with a recess in which the electric circuit 20c in the form of a board is mounted, and further with a pair of hooks 314 for fixing the electric circuit 20c.

The electric circuit 20c includes an almost circular electrically insulated substrate 23, circuit patterns 21 formed on the electrically insulated substrate 23, and electric components 22 mounted on the circuit patterns 21.

In order to electrically connect to the circuit patterns 21 of the electric circuit 20c, the first terminal part 321y of the wire section 32c is formed in the form of a press-fit type terminal. The first terminal part 321y electrically connects to the circuit patterns 21 through a through-hole formed through the electrically insulated substrate 23. The through-hole formed through the electrically insulated substrate 23 is covered at an inner surface thereof with a thin metal film which is a part of the electric circuit 20c.

Even if the housing 30c and the electric circuit 20c were separately formed, the same advantages as those provided by the first to fifth embodiments can be obtained by forming the first terminal part 321y of the wire section 32c in the form of a press-fit type terminal, and electrically connecting the first terminal part 321y to the circuit patterns 21.

Furthermore, by designing the first terminal part 321y to be of a press-fit type terminal, the first terminal part 321y and the electric circuit 20c are able to electrically connect to each other merely by inserting the electric circuit 20c to the flange 312c, ensuring that the electric circuit 20c comprising a circuit board can be readily mounted on the housing 30c.

### (Seventh Embodiment)

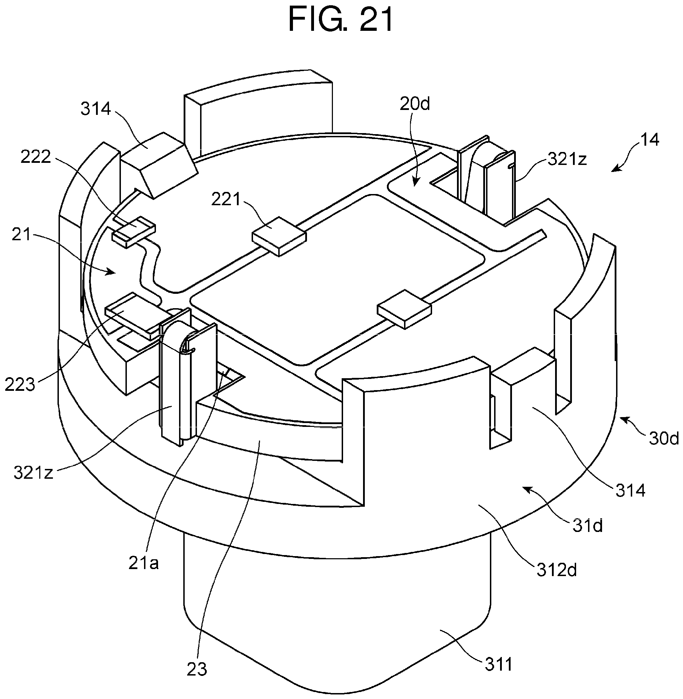

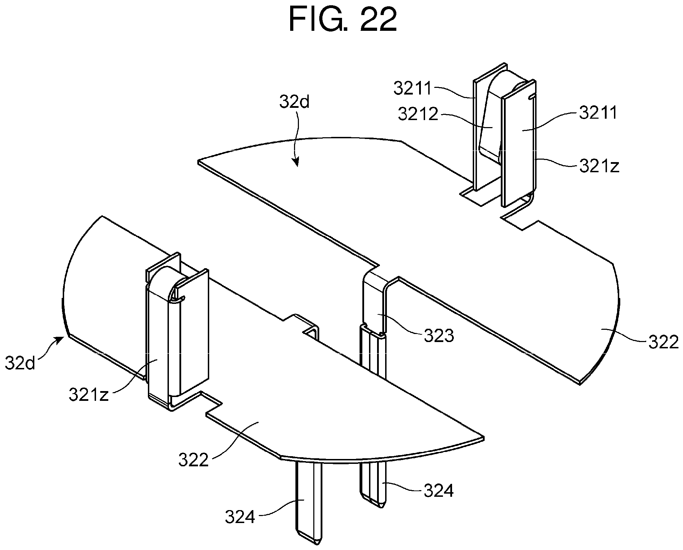

The housing in accordance with the seventh embodiment is explained hereinbelow with reference to drawings. In Figures 21 and 22, parts or elements that correspond to those of the first embodiment illustrated in Figures 1, 5, 20 and 22 have been provided with the same reference numerals, and operate in the same manner as corresponding parts or elements in the first embodiment, unless explicitly explained hereinbelow.

The housing in accordance with the seventh embodiment is characterized in that the wire section and the electric circuit 20 comprising a circuit board are electrically connected via a plate spring contact.

In the housing 30d to be used for LED lamp 14, illustrated in Figures 21 and 22, the flange 312d of the housing main body 31d is formed with a recess in which the electric circuit 20d in the form of a board is mounted, and further with a pair of hooks 314 for fixing the electric circuit 20d.

The electric circuit 20d includes side patterns 21a each formed at a vertically extending surface of a cut-out formed at the electrically insulated substrate 23, and making contact with the first terminal part 321z of the wire section 32d. The side pattern 21a electrically connects to the circuit patterns 21 formed on an upper surface of the electrically insulated substrate 23.

The first terminal part 321z includes a pair of sidewalls 3211 standing on the thermally conductive part 322 and facing each other, and a spring contact 3212 bent at a distal end thereof.

Even if the housing 30d and the electric circuit 20d were separately formed, the same advantages as those provided by the first to fifth embodiments can be obtained by forming the first terminal part 321z of the wire section 32d in the form of a press-fit type terminal, and electrically connecting the first terminal part 321z to the circuit patterns 21 via the side pattern 21a.

Furthermore, by designing the first terminal part 321z to make electrical contact with the side pattern 21a via the spring contact 3212, the first terminal part 321z and the electric circuit 20d are able to electrically connect to each other merely by inserting the electric circuit 20d to the flange 312d, ensuring that the electric circuit 20d comprising a circuit board can be readily mounted on the housing 30d.

Though LED is explained as an example of an electric component in the above-mentioned first to seventh embodiments, the present invention can be applied to any electric components such as a transistor, a diode, a resistor, a capacitor and a coil, as far as they generate heat when a current runs therethrough.

In the above-mentioned first to seventh embodiments, the thermally conductive part 322 is formed between two bending portions of the wire section. For instance, in Figures 8 and 9, the first to third thermally conductive parts 322x, 322y and 322z are connected to one another via the bending parts 325. In place, the thermally conductive part 322 may be bent or folded such that the thermally conductive part 322 acts also as the junction part 323 (see Figure 4), or the thermally conductive part 322 has an area equal to a total of areas of the first and second thermally conductive parts 322x and 322y.

The wire sections 32c and 32d in the sixth and seventh embodiments are designed to include a single thermally conductive part, they may be designed to include a multi-layered thermally conductive part, similarly to the second and third embodiments.

### INDUSTRIAL APPLICABILITY

The present invention makes it possible to prevent a temperature of an electric component which generates heat when a current runs therethrough, from rising. Accordingly, the present invention is preferably suitable to a housing used for an electric circuit mounting thereon electric components which generate heat and thus are kept at a high temperature. In particular, the present invention is suitable to a housing used for a LED lamp in which LED emits light.

## Claims

1. A housing (10) used for an electric part, including:
a wire section (32) electrically connected to an electric circuit (20) including an electric component (22); and
a housing body (31) composed of resin,
wherein
the wire section (32) includes:
a first terminal part (321) exposed at a surface of the housing body (31);
a second terminal part (324) exposed at a surface of the housing body (31); and
a thermally conductive part (322) formed between the first terminal part (321) and the second terminal part (324), and embedded in the housing body (31),
the thermally conductive part (322) having a width greater than the same of the first and second terminal parts (321, 324), **characterized in that**
the thermally conductive part (322) comprises a plurality of horizontally arranged layers or vertically arranged layers (322x, 322y, 322z),
the layers (322x, 322y, 322z) being arranged to be spaced away from one another,
adjacent layers (322x, 322y, 322z) being connected to each other through a bending part (325) formed at peripheries of the adjacent layers,
each of the layers (322x, 322y, 322z) being arranged in parallel with one another and being formed with at least one through-hole (326) into which a pole (PU1-PU6, PD1-PD6) is insertable perpendicularly to the layers (322x, 322y, 322z).

2. The housing as set forth in claim 1, wherein the thermally conductive part (322) has an area extensive almost over the housing body (31).

3. The housing as set forth in claim 1, wherein the wire section (32) is bent at least once.

4. The housing as set forth in claim 1, wherein a number of the layers is an odd number equal to or greater than 3.

5. The housing as set forth in any one of claims 1 to 3, wherein at least a part of the thermally conductive part (322) is exposed externally of the housing body (31).

6. The housing as set forth in claim 5, wherein at least a part of the thermally conductive part (322) horizontally and/or vertically projects externally of the housing body (31).

7. The housing as set forth in claim 5, wherein the housing body (31) is formed with at least one hole (330) leading to the thermally conductive part (322).

8. The housing as set forth in any one of claims 1 to 3, wherein the housing body (31) is formed by insert molding with the wire section (32) being embedded therein.

9. The housing as set forth in any one of claims 1 to 3, wherein the electric circuit (20) comprises a pattern (21) comprising a thin metal film electrically connected to the electric component, the pattern being formed by a wiring pattern transfer process in which a thin metal film sheet is dice-cut, and the dice-cut sheet is transferred to the housing body (31).

## Patentansprüche

1. Ein Gehäuse (10) für ein elektrisches Teil, mit:
einem Drahtabschnitt (32), der elektrisch mit einer elektrischen Schaltung (20) verbunden ist, die eine elektrische Komponente (22) enthält; und
einem aus Harz zusammengesetzten Gehäusekörper (31),
wobei
der Drahtabschnitt (32) Folgendes enthält:
ein erstes Anschlussteil (321), das an einer Oberfläche des Gehäusekörpers (31) freiliegt;
ein zweites Anschlussteil (324), das an einer Oberfläche des Gehäusekörpers (31) freiliegt; und
ein wärmeleitendes Teil (322), das zwischen dem ersten Anschlussteil (321) und dem zweiten Anschlussteil (324) ausgebildet und in den Gehäusekörper (31) eingebettet ist,
wobei das wärmeleitende Teil (322) eine größere Breite als das erste und das zweite Anschlussteil (321, 324) aufweist, **dadurch gekennzeichnet, dass**
das wärmeleitende Teil (322) zahlreiche horizontal angeordnete Schichten oder vertikal angeordnete Schichten (322x, 322y, 322z) umfasst,
die Schichten (322x, 322y, 322z) so angeordnet sind, dass sie voneinander beabstandet sind,
benachbarte Schichten (322x, 322y, 322z) miteinander durch ein Biegeteil (325) verbunden sind, das an Rändern der benachbarten Schichten gebildet ist,
wobei alle Schichten (322x, 322y, 322z) parallel zueinander angeordnet sind und jede Schicht mit mindestens einer Durchgangsöffnung (326) ausgebildet ist, in die senkrecht zu den Schichten (322x, 322y, 322z) ein Stab (PU1-PU6, PD1-PD6) einführbar ist.

2. Gehäuse nach Anspruch 1, wobei der wärmeleitende Teil (322) einen sich fast über den Gehäusekörper (31) erstreckenden Bereich aufweist.

3. Gehäuse nach Anspruch 1, wobei der Drahtabschnitt (32) mindestens einmal gebogen ist.

4. Gehäuse nach Anspruch 1, wobei eine Anzahl der Schichten eine ungerade Zahl gleich oder größer als 3 ist.

5. Gehäuse nach einem der Ansprüche 1 bis 3, wobei das wärmeleitende Teil (322) zumindest teilweise außerhalb des Gehäusekörpers (31) freiliegt.

6. Gehäuse nach Anspruch 5, wobei das wärmeleitende Teil (322) zumindest teilweise horizontal und/oder vertikal aus dem Gehäusekörper (31) vorsteht.

7. Gehäuse nach Anspruch 5, wobei der Gehäusekörper (31) mit mindestens einem zu dem wärmeleitenden Teil (322) führenden Loch (330) ausgebildet ist.

8. Gehäuse nach einem der Ansprüche 1 bis 3, wobei der Gehäusekörper (31) durch Umspritzen ausgebildet und der Drahtabschnitt (32) darin eingebettet ist.

9. Gehäuse nach einem der Ansprüche 1 bis 3, wobei die elektrische Schaltung (20) ein Muster (21) aufweist, das einen dünnen Metallfilm umfasst, der elektrisch mit der elektrischen Komponente verbunden ist, wobei das Muster durch ein Verdrahtungsmusterübertragungsverfahren gebildet ist, bei dem eine dünne Metallfolie würfelartig geschnitten bzw. auf dem Wafer aufgebracht wird und die würfelartig geschnittene Folie auf den Gehäusekörper (31) übertragen wird.

## Revendications

1. Boîtier (10) utilisé pour une partie électrique, incluant :
une section de fil (32) électriquement connectée à un circuit électrique (20) incluant un composant électrique (22) ; et
un corps de boîtier (31) composé de résine,
dans lequel
la section fil (32) inclut :
une première partie terminale (321) exposée au niveau d'une surface du corps de boîtier (31) ;
une deuxième partie terminale (324) exposée au niveau d'une surface du corps de boîtier (31) ; et
une partie thermoconductrice (322) formée entre la première partie terminale (321) et la deuxième partie terminale (324), et incorporée dans le corps de boîtier (31),
la partie thermoconductrice (322) ayant une largeur supérieure à celle des première et deuxième parties terminales (321, 324), **caractérisé en ce que**
la partie thermoconductrice (322) comprend une pluralité de couches agencées horizontalement ou de couches agencées verticalement (322x, 322y, 322z),
les couches (322x, 322y, 322z) étant agencées pour être espacées les unes des autres,
des couches adjacentes (322x, 322y, 322z) étant connectées les unes aux autres par le biais d'une partie de pliage (325) formée au niveau de périphéries des couches adjacentes,
chacune des couches (322x, 322y, 322z) étant agencée parallèlement aux autres et étant formée avec au moins un trou traversant (326) à l'intérieur duquel une broche (PU1-PU6, PD1-PD6) peut être introduite perpendiculairement aux couches (322x, 322y, 322z).

2. Boîtier utilisé selon la revendication 1, dans lequel la partie thermoconductrice (322) comporte une zone extensive presque sur le corps de boîtier (31).

3. Boîtier utilisé selon la revendication 1, dans lequel la section de fil (32) est pliée au moins une fois.

4. Boîtier utilisé selon la revendication 1, dans lequel un nombre des couches est un nombre impair égal ou supérieur à 3.

5. Boîtier utilisé selon l'une quelconque des revendications 1 à 3, dans lequel au moins une partie de la partie thermoconductrice (322) est exposée à l'extérieur du corps de boîtier (31).

6. Boîtier utilisé selon la revendication 5, dans lequel au moins une partie de la partie thermoconductrice (322) se projette horizontalement et/ou verticalement à l'extérieur du corps de boîtier (31).

7. Boîtier utilisé selon la revendication 5, dans lequel le corps de boîtier (31) est formé avec au moins un trou (330) menant à la partie thermoconductrice (322).

8. Boîtier utilisé selon l'une quelconque des revendications 1 à 3, dans lequel le corps de boîtier (31) est formé par moulage par insertion avec la section de fil (32) étant incorporée dans celui-ci.

9. Boîtier utilisé selon l'une quelconque des revendications 1 à 3, dans lequel le circuit électrique (20) comprend un motif (21) comprenant un film métallique mince électriquement connecté au composant électrique, le motif étant formé par un processus de transfert de motif de câblage dans lequel une feuille à film métallique mince est découpée en dés, et la feuille découpée en dés est transférée sur le corps de boîtier (31).
